# EUROPEAN PATENT SPECIFICATION

(11) **EP 0 667 622 B1**
(45) Date of publication and mention of the grant of the patent: **23.01.2002**
(21) Application number: 95101866.2
(22) Date of filing: 11.02.1995
(51) Int. Cl.: G11C 7/00

(54) **Electronic still camera**
Elektronische Standbildkamera
Caméra électronique pour images fixes

(30) Priority: 15.02.1994 JP 1822594
(43) Date of publication of application: 16.08.1995
(73) Proprietor: EASTMAN KODAK COMPANY, Rochester, New York 14650-2201 (US)
(72) Inventor: Takizawa, Yoshinori, Rochester, New York 14650-2201 (US); Niwa, Hisashi, Rochester, New York 14650-2201 (US); Kawagoe, Yoshito, Rochester, New York 14650-2201 (US)
(74) Representative: Lewandowsky, Klaus, Dipl.-Ing

(56) References cited:
- US-A- 4 855 779
- PATENT ABSTRACTS OF JAPAN vol. 16, no. 84 (E-1172) 28 February 1992 & JP-A-32 068 583 (RICOH CO.)

## Description

### BACKGROUND OF THE INVENTION

### Field of the Invention

The present invention relates to an electronic still camera, and more particularly to a memory system control apparatus that records digital image signals on an internal storage medium.

### Description of the Prior Art

Electronic still cameras that convert an object image to digital signals and store the signals are well-known. The image formed by means of an optical system is converted to electrical signals by means such as a charge-coupled device (CCD), for example, and the signals are stored on a storage medium provided in the camera. Electronic image signals are normally processed as digital signals, and after being subjected to required image processing or compression processing these signals are stored using a solid-state storage device, hard disk or other such storage medium.

Because the image signals thus obtained can be digitally processed, an electronic still camera has various advantages compared to an ordinary optical camera. For example, the electronic images can be subjected to special processing, image data not required can be selectively erased, the storage medium can be used repeatedly, and character data or other such data processed by another computer can be readily integrated. Thus, in addition to ordinary camera functions, electronic still cameras can also be broadly applied as computer terminal devices.

To give an electronic still camera portability, the camera body houses an optical system, image processing section and storage medium, and incorporates a microcomputer to control these devices. As is well known, the overall system functions such as image acquisition, storage of image data, communication with a host computer and other such functions are controlled by the microcomputer in accordance with a control program. This control program is incorporated in the microcomputer, or written into a separate, external program memory. Usually the program memory is a read-only memory (ROM) that retains the program data even when its electrical power is switched off.

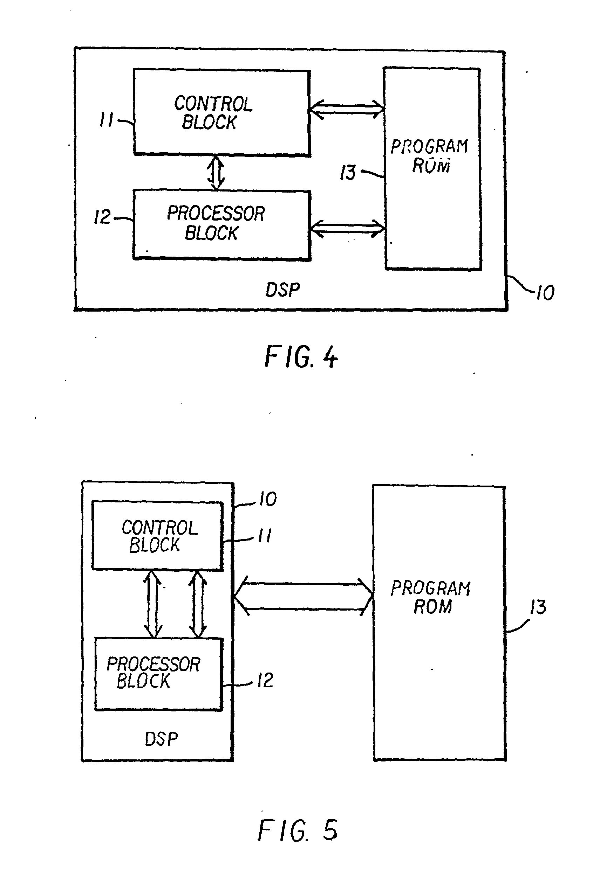

Figure 4 shows the internal arrangement of a conventional microcomputer 10 provided in a digital electronic still camera. Incorporated in the microcomputer 10 are a control block 11, a processor block 12 and a program ROM 13. A microcomputer such as microcomputer 10 is usually implemented as a microprocessor integrated circuit device, with the control block 11 providing control signals to each part of the electronic still camera (not shown) and controlling the required image storage in accordance with a program stored in the program ROM 13.

With this type of arrangement in which a program ROM is incorporated in a microcomputer, any alteration in the functions or specifications of the camera has to be effected by replacing the microprocessor that constitutes the microcomputer 10, which in practice is virtually impossible.

The program usually has to be modified or supplemented when camera specifications are altered or when there is an upgrade to a new version. Program changes are also required when a display device, computer, external storage device or other such external devices are connected to the camera, a need that has become stronger with the increasingly broad range of camera specifications. However, a problem with the conventional microcomputer 10 has been the difficulty in changing the program.

Figure 5 shows another conventional circuit arrangement in which the microcomputer 10 is provided with an external program ROM 13. The control arrangement with the microcomputer 10 is the same as in the arrangement of Figure 4. The arrangement of Figure 5 has the advantage that as the program ROM 13 is separate from the microcomputer 10, changes to the memory program specifications can be implemented by changing the program ROM 13. Even in this case, however, having to change the program ROM 13 is inconvenient for users, and the cost factor also makes it difficult, cancelling out the advantages of the electronic still camera.

From JP-A-3 268 583, against which the claims are delimited, an electronic still camera is known in which the user can add or change new features by inserting a memory card which stores the image data and the program data that controls the operations inside the electronic still camera. For every change in the program, a new memory card has to be provided or the memory card has to be reprogrammed.

A similar system is known from US-A-4,855,779 which shows a conventional film camera controlled by a microprocessor and comprising an exchangeable IC card (interated circuit card) which can store programs and data.

An object of the present invention is to provide an improved electronic still camera in which it is very easy to electrically alter or supplement the memory control program without replacing internal devices of the camera.

### SUMMARY OF THE INVENTION

In accordance with the present invention this object is attained by an electronic still camera according to claim 1.

Thus, as in accordance with this invention the program memory incorporated in the electronic still camera is rewritable and the program is written from an external apparatus via a communication circuit, it has the advantage of enabling the program to be very easily altered or supplemented without making any changes to the camera body.

Further features of the invention, its nature and various advantages will become more apparent from the accompanying drawings and the following detailed description of the invention.

### BRIEF DESCRIPTION OF THE DRAWINGS

Figure 1 is a block diagram showing a preferred first embodiment of the electronic still camera of this invention;
Figure 2 is a block circuit diagram showing the relationship between the microcomputer and the program memory in the embodiment of Figure 1;
Figure 3 is a block circuit diagram of a slightly modified version of the embodiment shown in Figure 2;
Figure 4 is an explanatory diagram of a conventional microcomputer configuration; and
Figure 5 is a diagram of a conventionally arrangement of the microcomputer and the program ROM of an electronic still camera.

### DESCRIPTION OF THE PREFERRED EMBODIMENT

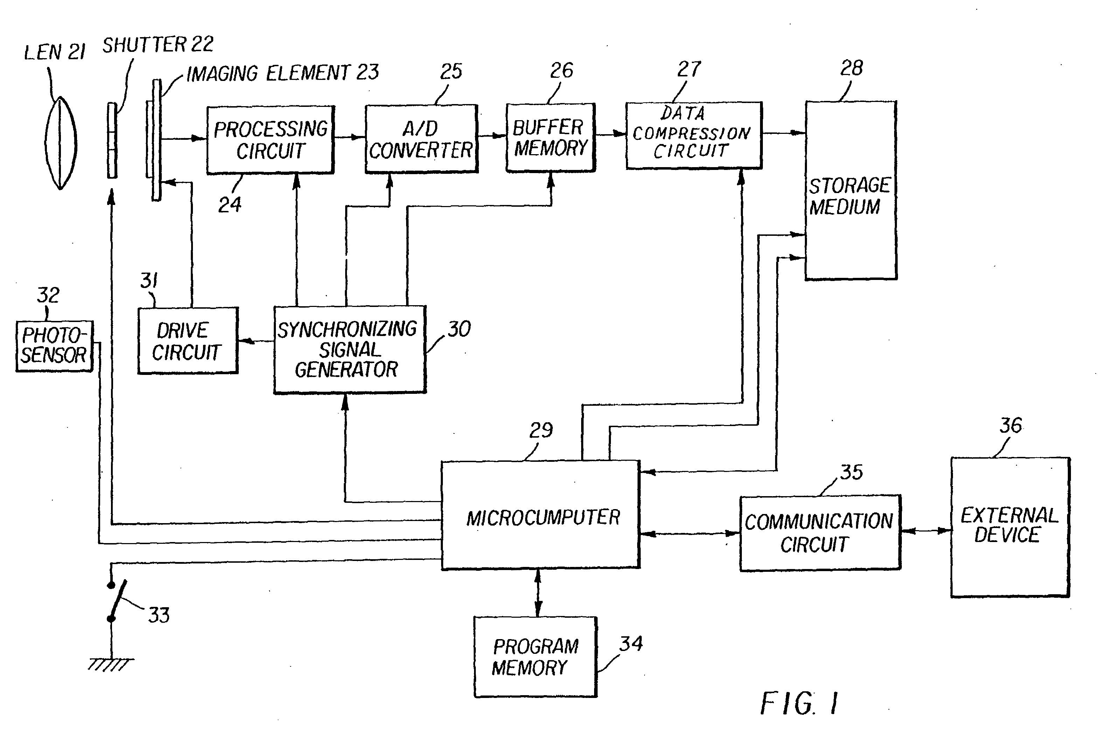

Figure 1 shows a preferred embodiment of the electronic still camera of this invention. An image of an object is formed on an imaging element 23 by an optical system that includes a lens 21 and shutter 22. The imaging element 23 is constituted by a CCD or the like that converts image information to analog electronic signals. Electronic signals output from the imaging element 23 are input to a preprocessing circuit 24, where the signals are subjected to noise filtration, white balance adjustment, gamma correction and other preprocessing, and are then digitized by an A/D converter 25.

Electronic signals output from the imaging element 23 are input to a preprocessing circuit 24, where the signals are subjected to noise filtration, white balance adjustment, gamma correction and other preprocessing, and are then digitized by an A/D converter 25. The digitized signals are sent to a buffer memory 26, and the data is then compressed by a data compression circuit 27 and stored in a storage medium 28. The storage medium 28 is a magnetic disk, RAM with data backup function, flash memory or other such storage means that retains the stored image data even when the power supply is interrupted.

In order to control the optical system, the processing circuitry and the storage medium, the electronic still camera contains a microcomputer 29 that in this embodiment directly controls the data compression circuit 27 and storage medium 28. The microcomputer 29 also controls a synchronizing signal generator 30 that supplies the A/D converter 25 and buffer memory 26 with a prescribed synchronizing signal. This synchronizing signal is also supplied to a drive circuit 31 that reads out signals from the imaging element 23. The camera is also provided with a photosensor 32 that can measure the illuminance of the object, and there is a release switch 33 that enables the user to switch the camera on and off.

The characterizing feature of this invention is that the electronic still camera incorporates a program memory 34 that can maintain the microcomputer 29 program so that the program can be rewritten. The program memory 34 is also arranged so that it retains the program data even when its electrical power supply is interrupted. A programmable ROM or the like is a suitable memory for this embodiment.

The electronic still camera in this embodiment is also provided with a communication circuit 35 that can be used as a link between the microcomputer 29 and an external device 36 such as a personal computer, for example, and also, if required, a display for displaying image data stored on the storage medium 28 and a hard disk for keeping data.

The operation of the first embodiment thus configured will now be described. The electronic still camera is activated by the user closing the release switch 33, whereby the microcomputer 29 detects the activation signal and starts camera operation. First, based on the output of the photosensor 32, the microcomputer 29 detects the brightness of the object and sets the speed of the shutter 22 and the aperture value. A well-known arrangement can be used in which the release switch 33 is interlocked with the hood of the lens 21, so that when the lens 21 is opened the shutter mechanism automatically goes into a standby mode that corresponds to the brightness of the object. Pressing a shutter button (not shown) causes the shutter 22 to be operated by the microcomputer 29, thereby exposing the imaging element 23 to the object image.

The image signals of the imaging element 23 are read out by the drive circuit 31 as a serial stream of analog signals. After image processing by the preprocessing circuit 24 these analog signals are converted to digital signals by A/D converter 25 and stored temporarily in buffer memory 26. The buffer memory 26 can usually hold one frame of data produced by a single exposure, but in order to store the data on the storage medium 28 the image data output from the buffer memory 26 is compressed by the data compression circuit 27. After the image data has been transferred to the storage medium 28, the next exposure can be prepared.

Thus, the object image is stored on the storage medium 28 in the form of electrical signals, with all the functions required to achieve this being controlled by the microcomputer 29, with the memory program being retained in rewritable form in the program memory 34, which is a characterizing feature of this invention. In accordance with this invention, changing the characteristics or specifications of this memory program, or upgrading the program, or modifying or supplementing the program to match the characteristics of an externally connected device, can be readily accomplished by rewriting the program in the program memory 34 from the external device 36 via the communication circuit 35, without changing the microcomputer 29 or program memory 34 inside the camera.

The communication circuit 35 includes a driver, a receiver and other such components, and under the control of the microcomputer 29 is used to send image data from the storage medium 28 to the external device 36, or to effect remote control of the camera from the external device 36. Remote control operation is useful when the camera is being used as a monitoring camera, for example, for which pictures of the area being monitored can be acquired at prescribed intervals in the form of electronic images. In addition to the usual functions described above, the communication circuit 35 can be used to permit the program memory 34 program to be readily modified or supplemented from the external device 36.

In this embodiment, rewriting the program can be accomplished by writing modifying or supplementing data from the external device 36 to the program memory 34 in accordance with a procedure set beforehand by the user, such as the transmission of a write signal from the external device 36 to the microcomputer 29. However, a user can also use the camera's switches for specific operating modes. The external device 36 thus sends new program data to the camera, the communication circuit 35 transfers this data to the microcomputer 29, and the microcomputer 29 writes the data to the program memory 34. Once this transfer has been completed, the camera operates in accordance with the new program.

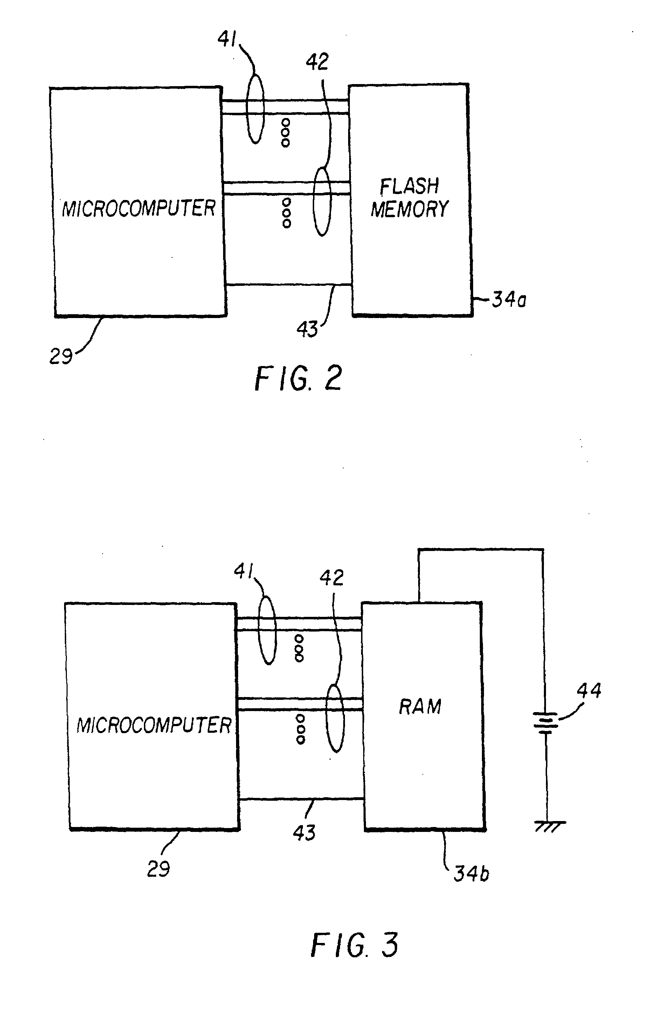

Figure 2 shows an example of the rewritable program memory constituted by flash memory. The flash memory 34a is connected to microcomputer 29 by an address bus 41, data bus 42 and control line 43. As the flash memory 34a retains the program data even when the power supply is switched off, the microcomputer 29 can be continuously provided with a program that matches the image processing functions of the camera. In the arrangement shown in Figure 3 the rewritable program memory 34 is a RAM 34b. The RAM 34b is connected to a backup battery 44 that keeps the RAM 34b supplied with operating power even when the main power supply is off, thus ensuring that program data is continuously maintained.

As has been described in the foregoing, with the electronic still camera of this invention the microcomputer program that controls the apparatus can be readily modified or supplemented without having to replace the microcomputer or program memory in the camera, facilitating upgrading and changes to camera specifications. The camera operating program can be changed to match the characteristics of an externally connected device such as, for example, a display or hard disk.

### Parts List :

### Figure 1

- 24: Preprocessing circuit
- 25: A/D converter
- 26: Buffer memory
- 27: Data compression circuit
- 28: Storage medium
- 29: Microcomputer
- 30: Synchronizing signal generator
- 31: Drive circuit
- 32: Photosensor
- 34: Rewritable program memory
- 35: Communication circuit
- 36: External device

### Figures 2 and 3

- 29: Microcomputer
- 41: Address bus
- 42: Data bus
- 43: Control line
- 44: Backup battery

### Figures 4 and 5

- 10: Microcomputer
- 11: Control block
- 12: Processor block
- 13: Program ROM

## Claims

1. An electronic still camera that converts images to digital electronic data and stores the data as image data on a storage medium (28) in the camera for use with an external device (36), the camera further including an internal microcomputer (29) that controls the processing of image data, a program memory (34a) in which a microcomputer program is maintained even when electrical power supply is interrupted, and a communication circuit (35) for reading external program data from the external device into the program memory,
**characterized in that** said external device is an external computer (36), and wherein the communication circuit (35) is configured to be operable to send image data from the camera to the external computer and to receive external program data from the external computer in accordance with a procedure of setting camera program data by a user, and to store said external program data in the program memory (34a) following the transmission of a write signal generated by the external computer in response to a user input.

2. An electronic still camera according to claim 1, wherein the communication circuit (35) transfers the external program data to the microcomputer (29), and the microcomputer (29) writes the data to the program memory (34a).

3. An electronic still camera according to claims 1 or 2, wherein the external program data supplied by the external computer (36) is used to perform a monitoring camera function, where pictures are acquired at prescribed intervals, or to enable a remote controlled operation of the camera.

## Patentansprüche

1. Elektronische Stehbildkamera, die Bilder in digitale elektronische *Daten* umwandelt und die Daten als Bilddaten in einem Speicher (28) der Kamera zur Verwendung mit einer externen Vorrichtung (36) speichert, mit einem internen Microcomputer (29), der die Verarbeitung der Bilddaten steuert, einem Programmspeicher (34a), in dem ein Microcomputer-Programm gespeichert bleibt, auch wenn die elektrische Stromversorgung unterbrochen ist, und mit einer Kommunikationsschaltung (35) zum Lesen externer Programmdaten von der externen Vorrichtung in den Programmspeicher,
**dadurch gekennzeichnet, dass** die externe Vorrichtung ein externer Rechner (36) ist und dass die Kommunikationsschaltung (35) derart ausgebildet ist, dass sie Bilddaten von der Kamera zum externen Rechner sendet und gemäß der Einstellung von Kameraprogrammdaten durch einen Benutzer externe Programmdaten vom externen Rechner empfängt, und dass sie im Anschluss an die Übertragung eines vom externen Rechner in Abhängigkeit von einer Eingabe durch den Benutzer erzeugten Schreibsignals die externen Programmdaten im Programmspeicher (34a) speichert.

2. Elektronische Stehbildkamera nach Anspruch 1, **dadurch gekennzeichnet, dass** die Kommunikationsschaltung (35) die externen Programmdaten zum Microcomputer (29) überträgt und dieser die Daten in den Programmspeicher (34a) schreibt.

3. Elektronische Stehbildkamera nach Anspruch 1 oder 2, **dadurch gekennzeichnet, dass** die vom externen Rechner (36) gelieferten Programmdaten zur Ausübung einer Kameraüberwachungsfunktion verwendbar sind, bei der Fotografien in vorgegebenen Zeitabständen erhaltbar sind, oder um eine ferngesteuerte Bedienung der Kamera zu ermöglichen.

## Revendications

1. Appareil photographique électronique qui convertit les images en données numériques électroniques et mémorise les données en tant que données image sur un support d'enregistrement (28) dans l'appareil photographique pour utilisation avec un dispositif externe (36), l'appareil photographique comprenant de plus un micro-ordinateur interne (29) qui commande le traitement des données image, une mémoire de programme (34a) dans laquelle un programme de micro-ordinateur est conservé même lorsque l'alimentation en courant électrique est interrompue et un circuit de communication (35) destiné à lire des données de programme externe provenant du dispositif externe dans la mémoire de programme,
**caractérisé en ce que** ledit dispositif externe est un ordinateur externe (36), et dans lequel le circuit de communication (35) est configuré afin d'être utilisable pour envoyer les données image à partir de l'appareil photographique à l'ordinateur externe et recevoir les données de programme externe de l'ordinateur externe conformément à une procédure d'établissement des données de programme d'appareil photographique par un utilisateur, et pour mémoriser lesdites données de programme externe dans la mémoire de programme (34a) en suivant la transmission d'un signal d'écriture généré par l'ordinateur externe en réponse à une entrée d'utilisateur.

2. Appareil photographique électronique selon la revendication 1 dans lequel le circuit de communication (35) transfère les données de programme externe au micro-ordinateur (29) et le micro-ordinateur (29) écrit les données dans la mémoire de programme (34a).

3. Appareil photographique électronique selon les revendications 1 ou 2 dans lequel les données de programme externe fournies par l'ordinateur externe (36) sont utilisées pour effectuer une fonction d'appareil photographique de surveillance dans lequel des images sont prises à des intervalles prescrits, ou de permettre une opération commandée à distance de l'appareil photographique.
